# EUROPEAN PATENT APPLICATION

(11) **EP 4 822 998 A1**
(43) Date of publication of application: **14.10.2026**
(21) Application number: 24900913.5
(22) Date of filing: 15.11.2024
(51) Int. Cl.: H04B 1/3822, B60L 53/66, H01Q 3/30, H05K 9/00, B60L 53/30, H01Q 1/32, H01Q 1/22, H04L 12/40

(54) **WIRELESS COMMUNICATION MODULE**

(30) Priority: 08.12.2023 KR 20230177635; 08.12.2023 KR 20230177672; 08.12.2023 KR 20230177714
(71) Applicant: LG Innotek Co., Ltd., Seoul 07796 (KR)
(72) Inventor: LEEM, Sung Hyun, Seoul 07796 (KR)
(74) Representative: Plasseraud IP
(86) International application number: PCT/KR2024/018016
(87) International publication number: WO 2025/121726

(57) **Abstract**

A wireless communication module according to an embodiment of the present invention includes: an antenna unit disposed in a first area of a substrate; and a Wi-Fi module disposed in a second area of the substrate, wherein the antenna unit includes a first antenna unit and a third antenna unit which are disposed on one side of the Wi-Fi module and are connected to each other, and the first antenna unit and the third antenna unit radiate signals having a phase difference.

## Description

### [Technical Field]

The present invention relates to a wireless communication module, and more specifically, to a wireless communication module that enhances communication performance through an antenna arrangement of the wireless communication module.

### [Background Art]

Eco-friendly vehicles, such as an electric vehicle (EV) or a plug-in hybrid electric vehicle (PHEV), use electric vehicle supply equipment (EVSE) installed in a charging station to charge a battery.

Various protocols are being actively established for the interaction between electric vehicles and EVSE. Protocols regarding electric vehicle charging can be broadly classified into charging systems, charging interfaces, and communication protocols.

However, since different protocols are adopted by each country or each automobile company, a charging device, a battery pack, and a battery management system (BMS) of an electric vehicle must be developed and designed for each protocol.

When designing a vehicle charging system, if power lines for slow charging, fast charging, and communication supply, as well as communication lines for conducting communication, are all included when charging an electric vehicle, there are problems in that wires become thick and costs increase. In addition, there is a problem in that a kiosk must be installed around a parking space for charging an electric vehicle, and charging can be performed only at a location where the kiosk is installed. In addition, there is a disadvantage in that only a predetermined charging speed can be provided when the kiosk is installed.

### [Detailed Description of the Invention]

### [Technical Subject]

A technical subject to be achieved by the present invention is to provide a wireless communication module that enhances communication performance through an antenna arrangement of the wireless communication module.

### [Technical Solution]

In order to solve the technical subject, a wireless communication module according to an embodiment of the present invention includes an antenna unit being disposed in a first area of a substrate; and a Wi-Fi module being disposed in a second area of the substrate, wherein the antenna unit includes a first antenna unit and a third antenna unit being disposed on one side of the Wi-Fi module and are connected to each other, and the first antenna unit and the third antenna unit radiate signals having a phase difference.

The antenna unit includes a second antenna unit and a fourth antenna unit being disposed on the other side of the Wi-Fi module and connected to each other, and the second antenna unit and the fourth antenna unit may radiate signals having a phase difference.

The phase difference between the first antenna unit and the third antenna unit and the phase difference between the second antenna unit and the fourth antenna unit may be different from each other.

The Wi-Fi module is connected to the first antenna unit through a second signal line being branched from a first signal line, and the Wi-Fi module may be connected to the third antenna unit through a third signal line being branched from the first signal line.

The lengths of the second signal line and the third signal line may be different from each other with respect to the first signal line.

In order to solve the technical subject, a wireless communication module according to an embodiment of the present invention includes a first case; a second case being coupled to the first case; a substrate being disposed in the second case; an antenna unit being disposed in a first area of the substrate; and a Wi-Fi module being disposed in a second area of the substrate, wherein the antenna unit includes a first antenna unit and a third antenna unit being disposed on one side of the Wi-Fi module and connected to each other, and the antenna unit includes a second antenna unit and a fourth antenna unit being disposed on the other side of the Wi-Fi module and connected to each other.

The first antenna unit and the third antenna unit radiate signals having a first phase difference, the second antenna unit and the fourth antenna unit radiate signals having a second phase difference, and the first phase difference and the second phase difference may be different from each other.

The Wi-Fi module is connected to the first antenna unit through a second signal line being branched from a first signal line, the Wi-Fi module is connected to the second antenna unit through a third signal line being branched from the first signal line, and the lengths of the second signal line and the third signal line may be different from each other with respect to the first signal line.

In order to solve the technical subject, a wireless communication module according to an embodiment of the present invention includes an antenna unit being disposed in a first area of a substrate; and a Wi-Fi module being disposed in a second area of the substrate, wherein the antenna unit includes a first antenna unit and a third antenna unit being disposed on one side of the Wi-Fi module and connected to each other, and includes a shielding part between the first area and the second area of the substrate.

The first antenna unit and the third antenna unit are not overlapped in a first axis direction and a second axis direction perpendicular to the first axis direction, and the shielding part includes a first shielding part facing the first antenna unit and a second shielding part facing the third antenna unit.

The antenna unit includes a second antenna unit and a fourth antenna unit being disposed on the other side of the Wi-Fi module and connected to each other, and the shielding part includes a third shielding part facing the second antenna unit and a fourth shielding part facing the fourth antenna unit.

The first shielding part and the second shielding part may form an obtuse angle.

The shielding part may be electrically connected to a ground part of the substrate.

In order to solve the technical subject, a wireless communication module according to another embodiment of the present invention includes a first case; a second case being coupled to the first case; a substrate being disposed in the second case; an antenna unit being disposed in a first area of the substrate; and a Wi-Fi module being disposed in a second area of the substrate, wherein the antenna unit includes a first antenna unit and a third antenna unit being disposed on one side of the Wi-Fi module and connected to each other, and includes a shielding part being disposed between the first area and the second area of the substrate.

The first antenna unit and the third antenna unit are not overlapped in a first axis direction and a second axis direction perpendicular to the first axis direction, and the shielding part may include a first shielding part facing the first antenna unit and a second shielding part facing the third antenna unit.

The antenna unit includes a second antenna unit and a fourth antenna unit being disposed on the other side of the Wi-Fi module and connected to each other, and the shielding part may include a third shielding part facing the second antenna unit and a fourth shielding part facing the fourth antenna unit.

The shielding part may be electrically connected to a ground part of the substrate.

In order to solve the technical subject, a wireless communication module according to an embodiment of the present invention includes a first antenna unit and a second antenna unit being disposed in a first area of a substrate; a first NFC antenna unit and a second NFC antenna unit being disposed in the first area of the substrate; and a Wi-Fi module being disposed in a second area of the substrate, wherein the first NFC antenna unit and the first antenna unit are disposed so as not to be overlapped in a first axis direction and a second axis direction perpendicular to the first axis direction, and the second NFC antenna unit and the second antenna unit are disposed so as not to be overlapped in the first axis direction and the second axis direction.

The first antenna unit and the second antenna unit are disposed to overlap in the first axis direction, and the first NFC antenna unit and the second NFC antenna unit may be disposed to be overlapped in the first axis direction.

An electric vehicle communication controller (EVCC) may be disposed in the second area of the substrate.

The first NFC antenna unit and the second NFC antenna unit may be embedded NFC antennas.

The first NFC antenna unit may be disposed to face one side of the Wi-Fi module, and the second NFC antenna unit may be disposed to face the other side of the Wi-Fi module.

In order to solve the technical subject, a wireless communication module according to another embodiment of the present invention includes a first case; a second case being coupled to the first case; a substrate being disposed in the second case; a first antenna unit and a second antenna unit being disposed in a first area of the substrate; a first NFC antenna unit and a second NFC antenna unit being disposed in the first area of the substrate; and a Wi-Fi module being disposed in a second area of the substrate, wherein the first NFC antenna unit and the first antenna unit are disposed so as not to be overlapped in a first axis direction and a second axis direction perpendicular to the first axis direction, and the second NFC antenna unit and the second antenna unit are disposed so as not to be overlapped in the first axis direction and the second axis direction.

The first antenna unit and the second antenna unit are disposed to be overlapped in the first axis direction, and the first NFC antenna unit and the second NFC antenna unit may be disposed to be overlapped in the first axis direction.

An electric vehicle communication controller (EVCC) may be disposed in the second area of the substrate.

### [Advantageous Effects]

According to embodiments of the present invention, direct or indirect effects due to separation of a power line and a communication line can be minimized, and occurrence of communication failure can be prevented when using high power.

In addition, a wireless environment can be established through a high-performance antenna, and coverage can be expanded through a plurality of antennas, thereby minimizing space constraints.

In addition, by arranging antennas at positions selected to minimize the influence of electric fields according to a Wi-Fi module and an EVCC module, a high-performance antenna with excellent passive performance can be developed.

In addition, an EVCC module having high-efficiency characteristics can be designed through an optimized design considering radiation pattern designs between a plurality of antennas.

In addition, charging and payment can be proceeded with through a Wi-Fi zone of an EVSE, a personal mobile terminal, or a vehicle without restrictions on the location where a vehicle charging kiosk is installed.

In addition, since a separate kiosk installation is not required, it is possible to add existing vehicle charging stations and expand charging facilities.

In addition, a radiation signal may have directivity in a specific direction according to the setting of an area, an arrangement interval, a position, and a phase difference of the antenna.

In addition, by disposing a shielding part coated with ferrite inside the communication device, it is possible to maximize the reduction of electromagnetic fields generated from electronic components inside the device as well as noise occurring outside the device, and signal interference can be minimized.

In addition, field interference can be minimized by including an NFC antenna that communicates through a field and a band different from those of the antenna unit.

### [Brief Description of Drawings]

FIGS. 1 to 3 are block diagrams of a wireless charging control apparatus according to an embodiment of the present invention.
FIG. 4 is a block diagram of a wireless charging control apparatus according to another embodiment of the present invention.
FIG. 5 is a block diagram of a wireless charging control apparatus according to another embodiment of the present invention.
FIG. 6 is a flowchart of a wireless charging control method according to an embodiment of the present invention.
FIG. 7 illustrates an appearance of a wireless communication module according to an embodiment of the present invention.
FIG. 8 is a block diagram of a wireless communication module according to an embodiment of the present invention.
FIG. 9 is an exploded perspective view of a wireless communication module according to an embodiment of the present invention.
FIGS. 10 and 11 illustrate a wireless communication module according to an embodiment of the present invention.
FIG. 12 is a block diagram of a wireless communication module according to another embodiment of the present invention.
FIG. 13 illustrates a wireless communication module according to another embodiment of the present invention.
FIGS. 14 and 15 are views for explaining a wireless communication module according to another embodiment of the present invention.
FIGS. 16 and 17 are views for explaining a wireless communication module according to still another embodiment of the present invention.
FIG. 18 is a block diagram of a wireless communication module according to another embodiment of the present invention.
FIG. 19 illustrates a wireless communication module according to another embodiment of the present invention.

### [BEST MODE]

Hereinafter, preferred embodiments of the present invention will be described in detail with reference to the accompanying drawings.

However, the technical idea of the present invention is not limited to some embodiments to be described, but may be implemented in various forms, and inside the scope of the technical idea of the present invention, one or more of the constituent elements may be selectively combined or substituted between embodiments.

In addition, the terms (including technical and scientific terms) used in the present embodiments, unless explicitly defined and described, can be interpreted as a meaning that can be generally understood by a person skilled in the art, and commonly used terms such as terms defined in the dictionary may be interpreted in consideration of the meaning of the context of the related technology.

In addition, terms used in the present specification are for describing embodiments and are not intended to limit the present invention.

In the present specification, the singular form may include the plural form unless specifically stated in the phrase, and when described as "at least one (or more than one) of A and B and C", it may include one or more of all combinations that can be combined with A, B, and C.

In addition, in describing the components of the present embodiments, terms such as first, second, A, B, (a), and (b) may be used. These terms are merely intended to distinguish the components from other components, and the terms do not limit the nature, order or sequence of the components.

And, when a component is described as being 'connected', 'coupled' or 'interconnected' to another component, the component is not only directly connected, coupled or interconnected to the other component, but may also include cases of being 'connected', 'coupled', or 'interconnected' due that another component between that other components.

In addition, when described as being formed or disposed in "on (above)" or "below (under)" of each component, "on (above)" or "below (under)" means that it includes not only the case where the two components are directly in contact with, but also the case where one or more other components are formed or disposed between the two components. In addition, when expressed as "on (above)" or "below (under)", the meaning of not only an upward direction but also a downward direction with respect to one component may be included.

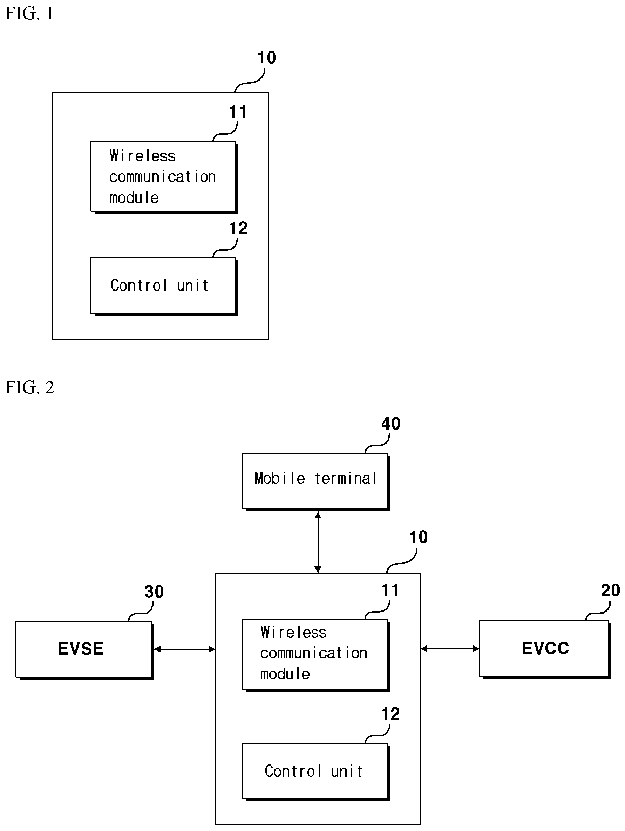

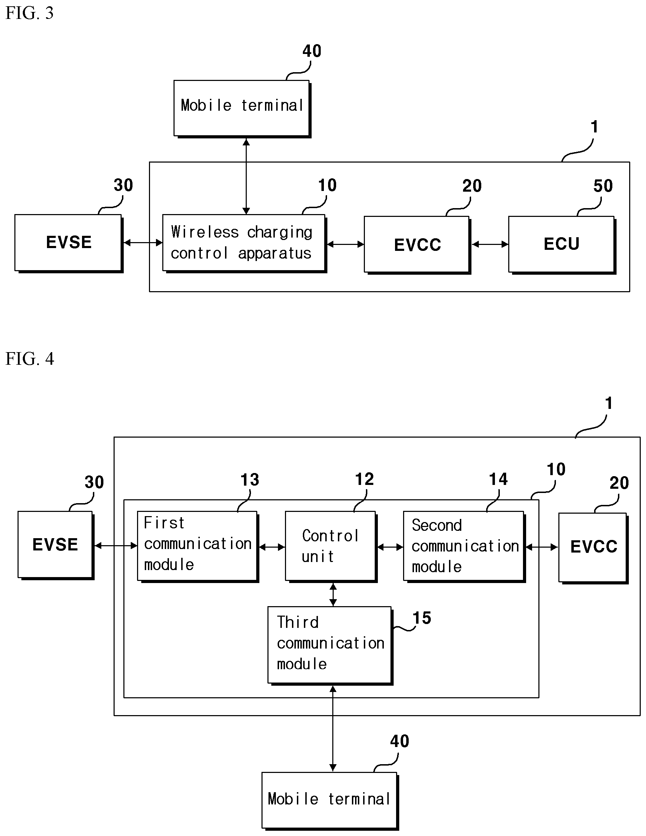

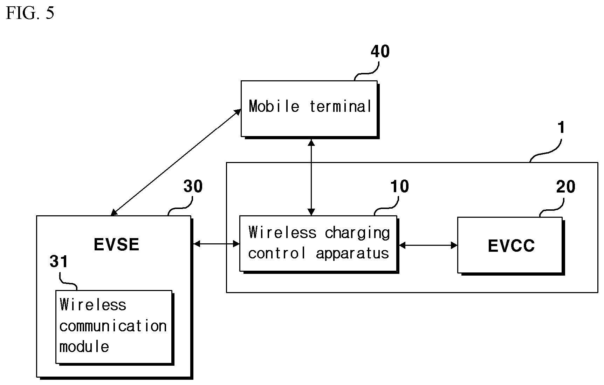

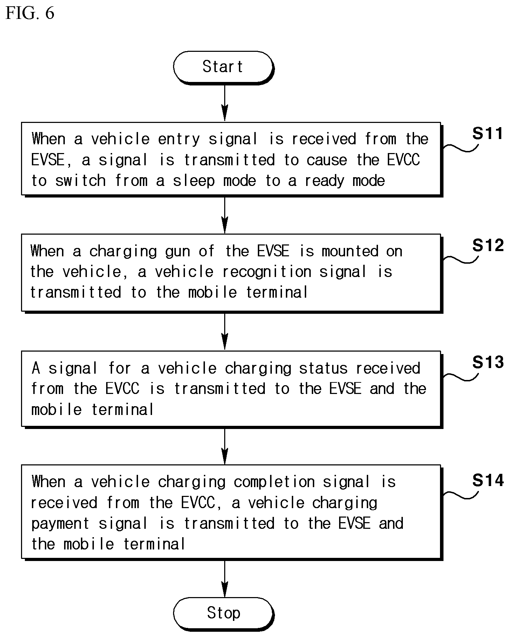

FIGS. 1 to 3 are block diagrams of a wireless charging control apparatus according to an embodiment of the present invention; FIG. 4 is a block diagram of a wireless charging control apparatus according to another embodiment of the present invention; FIG. 5 is a block diagram of a wireless charging control apparatus according to still another embodiment of the present invention; and FIG. 6 is a flowchart of a wireless charging control method according to an embodiment of the present invention.

Hereinafter, a wireless charging control apparatus 10 according to a first embodiment of the present invention will be described.

Referring to FIG. 1, a charging system including an electric vehicle according to the first embodiment of the present invention may include a vehicle **1** and electric vehicle supply equipment (EVSE) **30**. The vehicle **1** is an electric vehicle (EV) and may be charged from the EVSE **30**. In order for the vehicle **1** to receive charging power from the EVSE **30**, a charging cable connected to the EVSE **30** may be connected to an inlet of the vehicle **1**.

The EVSE **30** is an apparatus that supplies AC or DC and may be disposed in a charging station or disposed in a home. The EVSE **30** is not limited to a location and may be implemented to be portable. In this specification, the EVSE **30** may be used interchangeably with a supply, an AC supply, a DC supply, a socket-outlet, and the like.

An electric vehicle communication controller (EVCC) **20** is a component included in the vehicle **1** and may be connected to an electronic control unit (ECU) **50** in the vehicle **1**. The EVCC **20** may perform control of a charging signal and a charging power amount in the vehicle.

A wireless charging control apparatus **10** according to a first embodiment of the present invention may include a wireless communication module **11** and a control module **12**.

Although the wireless charging control apparatus **10** is described as a separate component from the EVCC **20**, the wireless charging control apparatus **10** may be a component included in the EVCC **20** to perform wireless communication with the EVCC **20**, the EVSE **30**, and a mobile terminal **40**. The wireless charging control apparatus **10** is a wireless communication charging control module, and the wireless charging control apparatus **10** may include a separate control module without being controlled by a micro control unit (MCU) of the EVCC **20**.

The wireless charging control apparatus **10** may issue an instruction for operating the MCU of the EVCC **20** through the control module **12** configured separately from the EVCC **20** via a signal received from the mobile terminal **40**. In addition, the wireless charging control apparatus **10** receives signals for vehicle charging and payment from the EVCC **20** and the EVSE **30** and transmits them to the mobile terminal **40**, thereby providing a service that allows a user to monitor a status of vehicle charging through the mobile terminal **40**.

The wireless communication module **11** may transmit and receive signals to and from the EVCC **20**, the EVSE **30**, and the mobile terminal **40**. The wireless communication module **11** may receive signals from the EVCC **20**, the EVSE **30**, and the mobile terminal **40**, and transmit the received signals to the control module **12**. In addition, the wireless communication module **11** may transmit a signal received from the control module **12** to at least one of the EVCC **20**, the EVSE **30**, and the mobile terminal **40**.

The wireless communication module **11** may include a Wi-Fi module and a short-range communication module. The wireless communication module **11** may include a wireless personal area network (W-PAN), a wireless local area network (W-LAN), and the like. The W-PAN may include ZigBee, Bluetooth, ultra-wideband (UWB), and the like, and the W-LAN may include Wi-Fi and the like. Although the wireless communication module **11** has been described as performing wireless communication, it is not particularly limited thereto, and it is natural that wired communication may be performed in addition to wireless communication.

The wireless communication module **11** may include a near field communication (NFC) module. NFC is a technology that enables communication between wireless devices at a short distance and is a type of non-contact short-range wireless communication using a 13.56 MHz radio frequency (RF) band. When the wireless communication module **11** is an NFC module, since the wireless communication module **11** and the EVSE **30** must be maintained at a short distance to perform communication, it may be mounted in various positions such as a side mirror of a vehicle or a driver's seat door.

When the wireless communication module **11** is an NFC module, the EVSE **30** may include an NFC reader to communicate with the NFC module in the vehicle **1**. When the vehicle **1** enters the area of the EVSE **30** and is in a short-range state where the NFC reader embedded in the EVSE **30** and the NFC module of the vehicle **1** can communicate with each other, communication regarding switching to a ready mode of the vehicle **1**, information on a vehicle charging status, and the like is possible.

The control module **12** may generate a control signal for the EVSE **30** and the EVCC **20** by using a signal received from the mobile terminal **40**. The control module **12** may generate a control signal for charging by using signals received from the EVCC **20**, the EVSE **30**, and the mobile terminal **40**.

The control module **12** may generate a separate control signal without being controlled by a micro control unit (MCU) of the EVCC **20**. The control module **12** of the wireless charging control apparatus **10** may be formed independently of a control module of the EVCC **20**. The control module **12** may receive a signal input by a user from the mobile terminal **40** and generate control signals for charging and billing to the EVCC **20** and the EVSE **30**.

The control module **12** may provide information on various vehicle charging statuses according to signals requested from the EVCC **20**, the EVSE **30**, and the mobile terminal **40**. The information on the vehicle charging status may include various types of information.

For example, the charging status information may include information on a charging mode, battery charging reservation, battery charging start/end, a charging error, charging control, a charging current, voltage, power, and the like. The battery status information may include information on a battery state of charge (SOC), a battery temperature (internal/external cell temperature), a voltage/current charging constant, and the like. The authentication information may include information on a vehicle ID, a user ID, an EVSE ID, and the like. The charging billing information may include information on a power rate, a charging time, load information, meter data, billing data, and the like.

The control module **12** may generate control signals transmitted to the EVCC **20**, the EVSE **30**, and the mobile terminal **40** according to a charging stage. Hereinafter, although the control module **12** is described as transmitting and receiving control signals, the signals generated by the control module **12** may be transmitted to and received from each component through the wireless communication module **11**.

When the vehicle **1** enters the area of the EVSE **30**, the control module **12** may receive an entry signal of the EVSE **30** and transmit a signal for causing the EVCC **20** to switch from a sleep mode to a ready mode. When a charging gun of the EVSE **30** is mounted on the vehicle **1**, the control module **12** may transmit a vehicle recognition signal to the mobile terminal **40**. Alternatively, when entering a charging area of the EVSE **30** where wireless charging is performed, the control module **12** may transmit a vehicle recognition signal to the mobile terminal **40**.

Thereafter, when a signal for a vehicle charging start request is received from the mobile terminal **40**, the control module **12** may transmit a charging start signal to the EVSE **30** and the EVCC **20**. The control module **12** may provide information on a vehicle charging status received from the EVCC **20** according to a request signal of the mobile terminal **40** or a request signal of the EVSE **30** during charging. If a problem occurs in the vehicle, the battery, or the EVSE during charging, the control module **12**, having received a problem occurrence signal from each component, may transmit a signal notifying the mobile terminal **40** that a problem has occurred and provide guidance to take measures therefor.

When receiving a vehicle charging completion signal from the EVCC **20**, the control module **12** may transmit vehicle charging billing information and a payment signal received from the EVSE **30** to the mobile terminal **40**. A user may pay a vehicle charging fee through the mobile terminal **40**. Thereafter, the charging gun of the EVSE **30** is detached from the vehicle **1**, and the vehicle charging is completed.

Referring to FIG. 5, the EVSE **30** may include a wireless communication module **31** to directly transmit and receive control signals according to a vehicle charging operation to and from the mobile terminal **40**. Through this, the EVSE **30** may directly transmit and receive signals to and from the mobile terminal **40** without passing through the wireless charging control apparatus **10** included in the vehicle **1**.

According to embodiments of the present invention, it is possible to minimize direct or indirect effects due to the separation of a power line and a communication line, prevent the occurrence of communication failure when using high power, create a wireless environment through a high-performance antenna, and minimize location restrictions by expanding coverage. In addition, charging and payment can be proceeded with through a Wi-Fi zone of an EVSE, a personal mobile terminal, or a vehicle without restrictions on a location where a vehicle charging kiosk is installed, and since a separate kiosk installation is not required, it is possible to add existing vehicle charging stations and expand charging facilities.

Hereinafter, a wireless charging control apparatus **10** according to a second embodiment of the present invention will be described with reference to FIG. 4. The description of the first embodiment of the present invention may be applied to the second embodiment of the present invention, and redundant descriptions will be omitted.

Referring to FIG. 4, the wireless charging control apparatus **10** according to the second embodiment of the present invention may include a first communication module **13**, a second communication module **14**, a third communication module **15**, and a control module **12**.

The first communication module **13** may transmit and receive signals to and from the EVSE **30**. The first communication module **13** may be implemented by a protocol supporting power line communication (PLC). The second communication module **14** may transmit and receive signals to and from the EVCC **20**. The second communication module **14** may be implemented by a protocol supporting a controller area network (CAN).

The third communication module **15** may transmit and receive signals to and from the mobile terminal **40**. The third communication module **15** may include a Wi-Fi module and a short-range communication module. The third communication module **15** may include a wireless personal area network (W-PAN), a wireless local area network (W-LAN), and the like. The W-PAN may include ZigBee, Bluetooth, ultra-wideband (UWB), and the like, and the W-LAN may include Wi-Fi and the like. The third communication module **15** may be a component corresponding to the wireless communication module **11** included in the first embodiment of the present invention.

The wireless charging control apparatus **10** according to the second embodiment of the present invention may transmit and receive signals through an NFC function. The first communication module **13** communicating with the EVSE **30** may include an NFC module. In this case, the EVSE **30** may include an NFC reader to communicate with the NFC module, which is the first communication module **13**. A charging gun of the EVSE **30** may include the NFC reader. The third communication module **15** communicating with the mobile terminal **40** may include an NFC module. In this case, the mobile terminal **40** may include an NFC reader to communicate with the NFC module, which is the third communication module **15**. The first to third communication modules **13, 14,** and **15** may include communication modules for communicating through NFC technology.

The control module **12** is connected to the first to third communication modules **13, 14,** and **15** and may generate control signals for the EVCC **20** and the EVSE **30** by using a signal received from the third communication module **15**. More specifically, the control module **12** generates a charging control signal using signals from the EVCC **20**, the EVSE **30**, and the mobile terminal **40**, and the generated charging control signal may be transmitted through the first to third communication modules **13, 14,** and **15** respectively connected to the EVCC **20**, the EVSE **30**, and the mobile terminal **40**. The control module **12** may be a component formed independently of a control module of the EVCC **20**.

FIG. 6 is a flowchart of a wireless charging control method according to an embodiment of the present invention. Since the detailed description of each step of FIG. 6 corresponds to the detailed description of the wireless charging control apparatus of FIGS. 1 to 5, redundant descriptions will be omitted hereinafter.

In a wireless charging control apparatus for controlling vehicle charging by transmitting and receiving signals to and from an EVSE, an EVCC, and a mobile terminal, in step **S11**, when a vehicle entry signal is received from the EVSE, a signal is transmitted to cause the EVCC to switch from a sleep mode to a ready mode; in step **S12**, when a charging gun of the EVSE is mounted on the vehicle, a vehicle recognition signal is transmitted to the mobile terminal and a signal is transmitted to cause the EVCC to switch from the ready mode to a charging mode; in step **S13**, a signal for a vehicle charging status received from the EVCC is transmitted to the EVSE and the mobile terminal; and in step **S14**, when a vehicle charging completion signal is received from the EVCC, a vehicle charging payment signal is transmitted to the EVSE and the mobile terminal. The signal for the vehicle charging status may include at least one of a charging speed, charging billing, a charging amount, and a remaining charging time.

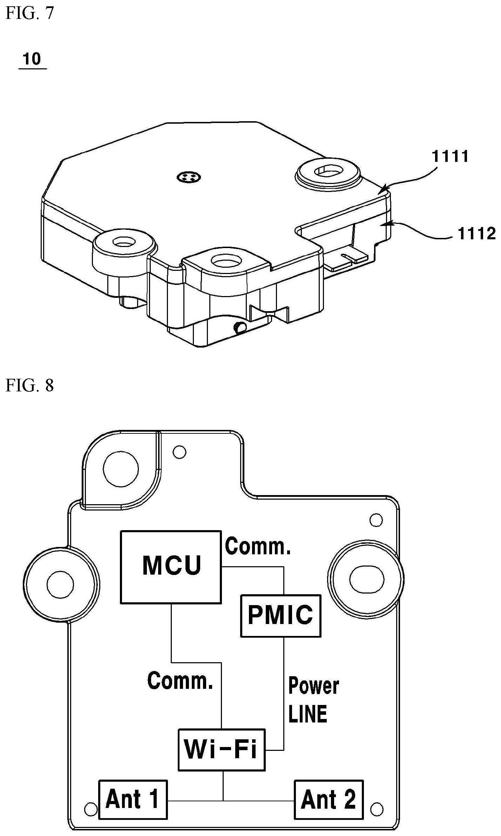

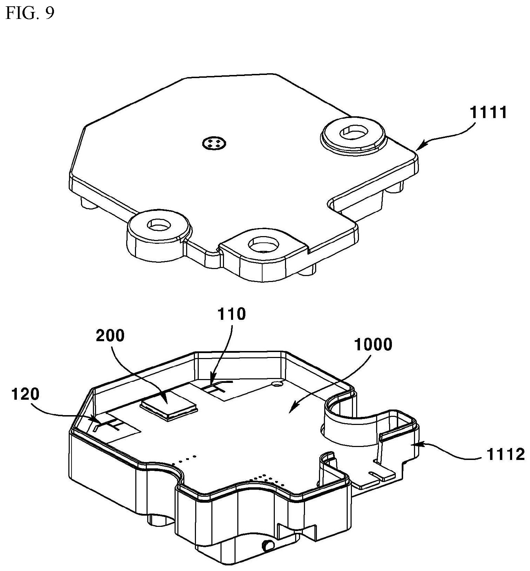

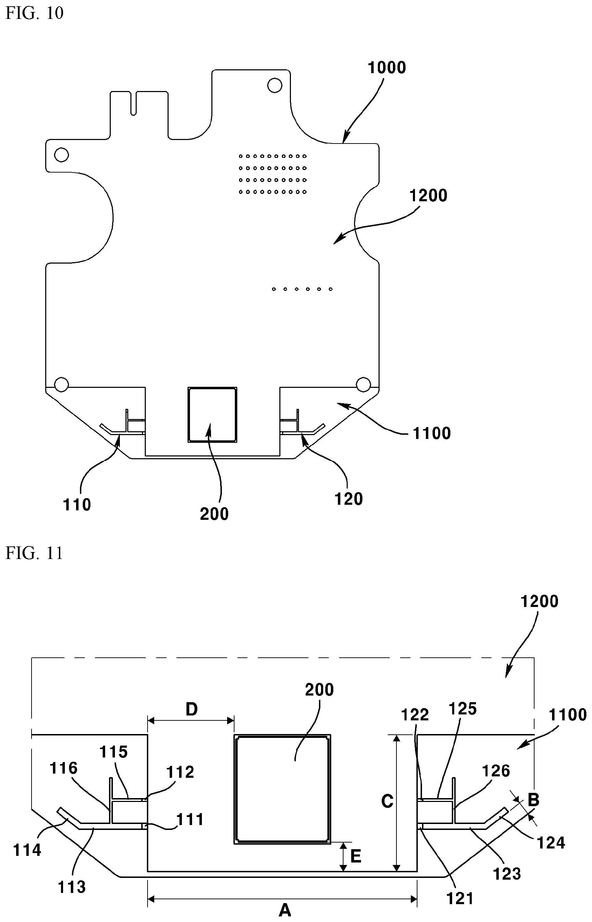

FIG. 7 illustrates an appearance of a wireless communication module according to an embodiment of the present invention; FIG. 8 is a block diagram of a wireless communication module according to an embodiment of the present invention; FIG. 9 is an exploded perspective view of a wireless communication module according to an embodiment of the present invention; and FIGS. 10 and 11 illustrate a wireless communication module according to an embodiment of the present invention.

A wireless communication module **10** according to an embodiment of the present invention may include a first antenna unit **110** and a second antenna unit **120** disposed in a first area **1100** of a substrate **1000**, and a Wi-Fi module **200** disposed in a second area **1200** of the substrate **1000**. In the second area **1200** of the substrate **1000**, an EVCC may be disposed in addition to the Wi-Fi module **200**. The second area **1200** of the substrate **1000** may be divided into a third area where the Wi-Fi module **200** is disposed and a fourth area where the EVCC is disposed. The third area of the substrate **1000** may be formed in a shape protruding from the fourth area. The first antenna unit **110** and the second antenna unit **120** may be disposed at an edge of the substrate **1000**, which is an area for minimizing electromagnetic compatibility (EMC) occurring in a circuit of the substrate **1000**.

The wireless communication module **10** may include a first case **1111** and a second case **1112** coupled to the first case **1111**. The substrate **1000** may be disposed in the second case **1112**. The substrate **1000** may be disposed in an internal space formed by the coupling of the first case **1111** and the second case **1112**. The first case **1111** and the second case **1112** may be referred to as a first body and a second body. The first case **1111** and the second case **1112** may be referred to as a first cover and a second cover. The first case **1111** and the second case **1112** may be referred to as an upper cover and a lower cover.

The first antenna unit **110** and the second antenna unit **120** may include a short-range communication module. The first antenna unit **110** and the second antenna unit **120** may include a Bluetooth antenna. A shield can may be disposed on an upper portion of the Wi-Fi module **200**. A cover may be disposed on the upper portion of the Wi-Fi module **200**.

The first antenna unit **110** and the second antenna unit **120** may be spaced apart from the Wi-Fi module **200** by a predetermined distance in order to minimize the influence of parasitic capacitance caused by the shield can of the Wi-Fi module **200**, which affects antenna performance. Through this, even if the Wi-Fi and Bluetooth antennas, which are ultra-small modules, are adjacent to each other, signal interference between them can be minimized, and a wireless Wi-Fi transmission rate can be secured during simultaneous operation with Bluetooth.

The first antenna unit **110** may be disposed to face one side of the Wi-Fi module **200**, and the second antenna unit **120** may be disposed to face the other side of the Wi-Fi module **200**. The first antenna unit **110** and the second antenna unit **120** may be disposed symmetrically with respect to the Wi-Fi module **200**. The first antenna unit **110** and the second antenna unit **120** may be formed in the same shape and may be formed in a symmetrical shape with respect to the Wi-Fi module **200**. The first antenna unit **110** and the second antenna unit **120** may be a configuration of a multiple-input multiple-output (MIMO) antenna. Since the first antenna unit **110** and the second antenna unit **120** are disposed to be spaced apart from each other around the Wi-Fi module **200**, mutual interference of electromagnetic waves can be prevented, and isolation can be enhanced.

A plurality of radiating parts having various frequency bands for various communications may be formed in the first antenna unit **110** and the second antenna unit **120**. In particular, radiating parts for Wi-Fi, Bluetooth, GPS, and NFC may be required for short-range communication.

Each of the first antenna unit **110** and the second antenna unit **120** may include feeding parts **111** and **121** connected to the first area **1100** of the substrate **1000**, a first radiating part connected to the feeding parts **111** and **121**, a second radiating part connected to the first radiating part, and grounding parts **112** and **122** connecting the second radiating part and the first area **1100** of the substrate **1000**. Current is applied to each of the first antenna unit **110** and the second antenna unit **120** through the feeding parts **111** and **121**, and the first radiating part and the second radiating part radiate signals having predetermined frequency bands to the outside, respectively, according to the current applied through the feeding parts **111** and **121**. In this case, the signals are implemented such that phases of the signals radiated through respective radiation patterns forming the first radiating part and the second radiating part are different from each other.

The first antenna unit **110** and the second antenna unit **120** may be PIFA antennas. A planar inverted-F antenna (PIFA) refers to a planar antenna in which a square patch plate of a smaller area is placed on a ground plane of a flat plate as if an "F" were turned upside down. The PIFA antenna may be composed of a ground plane, a radiation patch, a feeding part, and a shorting part (a shorting pin or a shorting strip). The PIFA antenna serves as a radiating element as the patch resonates with the ground plane by current feeding, and a bandwidth, a gain, a resonance frequency, and the like may be determined according to the length, width, and height of the patch, and the positions of a feed line and the shorting pin.

The first radiating part may include first patterns **113** and **123** connected to the feeding parts **111** and **121**, and second patterns **114** and **124** extending from one end of the first patterns **113** and **123**. The second radiating part may include third patterns **115** and **125** connected to the grounding parts **112** and **122**, and fourth patterns **116** and **126** perpendicular to the third patterns **115** and **125**. The first patterns **113** and **123** and the second patterns **114** and **124** may be disposed to form an obtuse angle. The second patterns **114** and **124** may be disposed to be parallel to one side of the substrate **1000**. Each radiating part may be formed in various shapes and may vary depending on the design of the radiating part.

The first radiating part and the second radiating part may be a radiating part for Wi-Fi or a radiating part for Bluetooth. Alternatively, they may be radiating parts for other communications, such as a radiating part for NFC. The first radiating part and the second radiating part may be radiating parts for different purposes, or may be radiating parts for the same purpose. The width of the first radiating part may be formed to be larger than the width of the second radiating part. The first radiating part may cause resonance in a frequency band of 5.0 GHz to 5.2 GHz. The second radiating part may cause resonance in a frequency band of 2.4 GHz to 2.5 GHz.

Referring to FIG. 11, The distance **A** between the first antenna unit **110** and the second antenna unit **120** may be 46.5 mm or more and 48 mm or less, and may be about 47.4 mm. The distance **B** between the second patterns **114** and **124** and a side surface of the substrate **1000** facing the second patterns **114** and **124** may be 0.2 mm or more and 1 mm or less, and may be about 0.5 mm. The distance **C** between the third area of the substrate **1000** where the Wi-Fi module **200** is disposed and one side surface of the substrate **1000** may be 23.5 mm or more and 24.5 mm or less, and may be about 24 mm. The distance **D** between the Wi-Fi module **200** and the first antenna unit **110** may be 14.5 mm or more and 16 mm or less, and may be about 15.2 mm. The distance **E** between the Wi-Fi module **200** and a side surface of the substrate **1000** facing the Wi-Fi module **200** may be 4 mm or more and 5.5 mm or less, and may be about 4.8 mm. It is natural that the shape of the first antenna unit **110** according to FIG. 11, and the length and spacing of each radiating part may vary according to antenna characteristics.

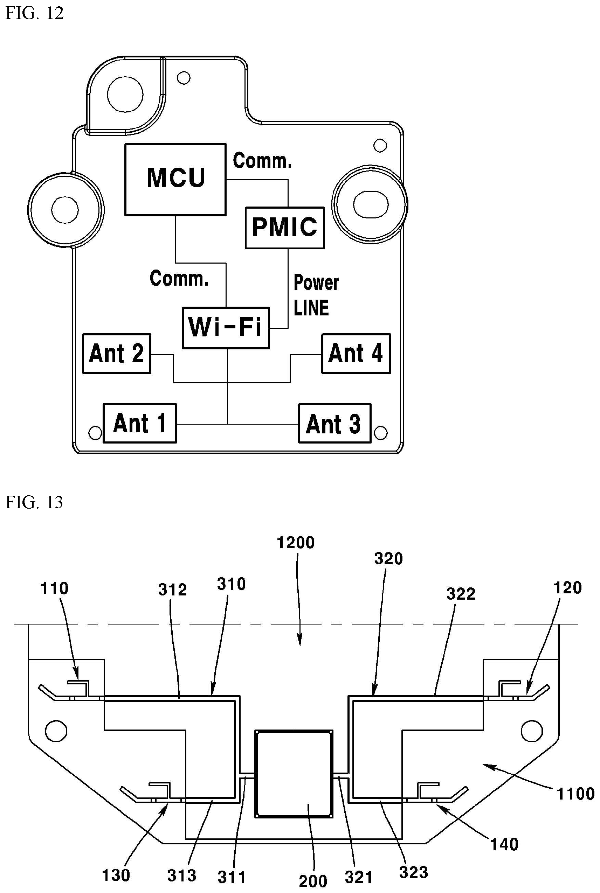

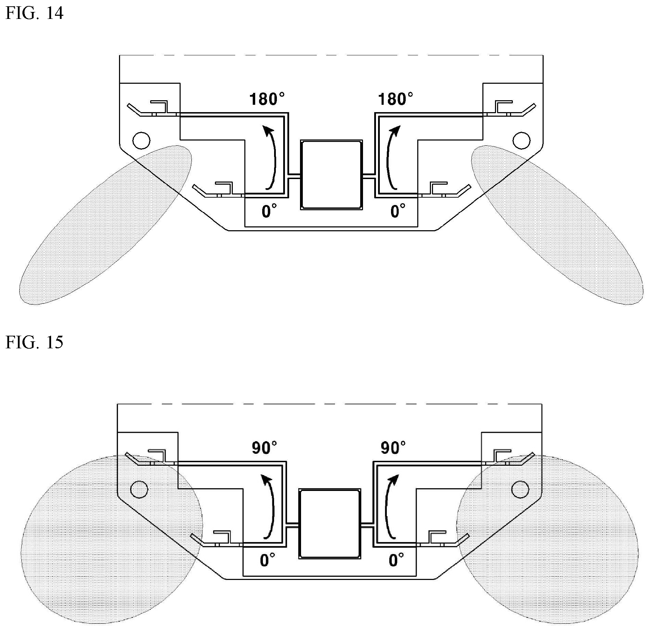

FIG. 12 is a block diagram of a wireless communication module according to another embodiment of the present invention; FIG. 13 illustrates a wireless communication module according to another embodiment of the present invention; and FIGS. 14 and 15 are views for explaining a wireless communication module according to another embodiment of the present invention.

A wireless communication module **10** according to another embodiment of the present invention may further include a third antenna unit **130** and a fourth antenna unit **140**. Referring to FIG. 13, a first antenna unit **110**, a second antenna unit **120**, a third antenna unit **130**, and a fourth antenna unit **140** may be connected to a Wi-Fi module **200**. The first antenna unit **110** and the third antenna unit **130** may be connected to each other. The Wi-Fi module **200** may be connected to the first antenna unit **110** through a second signal line **312** being branched from a first signal line **311**. The Wi-Fi module **200** may be connected to the third antenna unit **130** through a third signal line **313** being branched from the first signal line **311**. The lengths of the second signal line **312** and the third signal line **313** being connected from the first signal line **311** may be different from each other.

A second antenna unit **120** and a fourth antenna unit **140** may be connected to each other. A Wi-Fi module **200** may be connected to the second antenna unit **120** through a fifth signal line **322** being branched from a fourth signal line **321**. The Wi-Fi module **200** may be connected to the fourth antenna unit **140** through a sixth signal line **323** being branched from the fourth signal line **321**. The lengths of the fifth signal line **322** and the sixth signal line **323** being connected from the fourth signal line **321** may be different from each other.

A first antenna unit **110** and a third antenna unit **130** may be disposed parallel to each other. The first antenna unit **110** and the third antenna unit **130** may be disposed to face a direction of one side of a substrate **1000**. The first antenna unit **110** and the third antenna unit **130** may be disposed so as not to be overlapped in a first axis direction and a second axis direction perpendicular to the first axis direction. The second antenna unit **120** and the fourth antenna unit **140** may be disposed parallel to each other. The second antenna unit **120** and the fourth antenna unit **140** may be disposed to face a direction of the other side of the substrate **1000**. The second antenna unit **120** and the fourth antenna unit **140** may be disposed so as not to be overlapped in the first axis direction and the second axis direction.

By applying a pattern considering a voltage distribution ratio and a phase difference to an antenna unit, a radiation form of a signal may be adjusted so that a radiation signal has directivity for a specific direction. Through this, a signal radiated from the antenna unit may be beam-formed. Here, beam forming refers to a technology that concentrates a signal at a receiving device located in a specific direction instead of radiating the signal from an antenna in all directions.

Through this, it is possible to enhance the quality of a signal transmitted to a signal receiver without amplifying transmission power in the antenna unit. In addition, it is possible to speed up information transmission and minimize the occurrence of signal errors. Furthermore, since signals are not radiated in unnecessary directions, signal interference can be minimized. Also, by using a plurality of antennas to adjust a phase and power intensity, a dead zone can be eliminated in a place where a wireless communication module is installed.

Referring to FIG. 14, a first antenna unit **110** may radiate a signal having a phase difference of 180° with respect to a third antenna unit **130**. When the first antenna unit **110** and the third antenna unit **130** are radiated to have a phase difference of 180°, beam forming may be performed between the first antenna unit **110** and the third antenna unit **130**. A second antenna unit **120** may radiate a signal having a phase difference of 180° with respect to a fourth antenna unit **140**. When the second antenna unit **120** and the fourth antenna unit **140** are radiated to have a phase difference of 180°, beam forming may be performed between the second antenna unit **120** and the fourth antenna unit **140**. Signals having the same phase difference may be radiated from the first antenna unit **110** and the third antenna unit **130** and the second antenna unit **120** and the fourth antenna unit **140**. Signals having different phase differences may be radiated from the first antenna unit **110** and the third antenna unit **130** and the second antenna unit **120** and the fourth antenna unit **140**.

Referring to FIG. **15**, a first antenna unit **110** may radiate a signal having a phase difference of 90° with respect to a third antenna unit **130**. A second antenna unit **120** may radiate a signal having a phase difference of 90° with respect to a fourth antenna unit **140**. When the first antenna unit **110** and the third antenna unit **130** are radiated to have a phase difference of 90°, beam forming may be performed with a steering distance smaller and an area wider than when they are radiated to have a phase difference of 180°. When the second antenna unit **120** and the fourth antenna unit **140** are radiated to have a phase difference of 90°, beam forming may be performed with a steering distance smaller and an area wider than when they are radiated to have a phase difference of 180°.

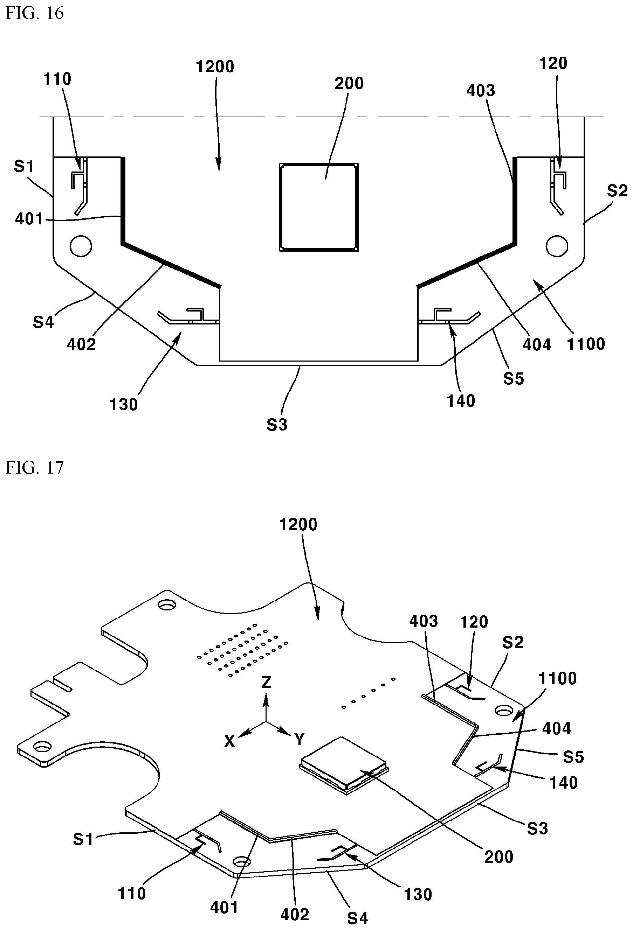

FIGS. 16 and 17 are views for explaining a wireless communication module according to still another embodiment of the present invention.

A wireless communication module **10** according to still another embodiment of the present invention may include shielding parts **401**, **402**, **403**, and **404** between a first area **1100** and a second area **1200** of a substrate **1000**. The shielding parts **401**, **402**, **403**, and **404** may be disposed perpendicularly to the substrate **1000**. The shielding parts **401**, **402**, **403**, and **404** may be made of a material including at least one of aluminum (Al) and copper (Cu). A shielding agent may be coated on surfaces of the shielding parts **401**, **402**, **403**, and **404**. A radio wave absorber may be coated on the surfaces of the shielding parts **401**, **402**, **403**, and **404**. Ferrite may be coated on the surfaces of the shielding parts **401**, **402**, **403**, and **404**. Ferrite may be coated on at least one of an inner surface and an outer surface of the shielding parts **401**, **402**, **403**, and **404**.

Referring to FIG. 16, a first antenna unit **110** may be disposed adjacent to a first side surface **S1** of a substrate **1000**. A third antenna unit **130** may be disposed adjacent to a fourth side surface **S4** being connected to the first side surface **S1** and a third side surface **S3** being connected to the fourth side surface **S4**. The first side surface **S1** and the fourth side surface **S4** of the substrate **1000** may form an obtuse angle, and the fourth side surface **S4** and the third side surface **S3** may form an obtuse angle. A first shielding part **401** may be disposed to face the first antenna unit **110**. A second shielding part **402** may be disposed to face the third antenna unit **130**. The first shielding part **401** and the second shielding part **402** may form an obtuse angle with each other.

A second antenna unit **120** may be disposed adjacent to a second side surface **S2** of the substrate **1000**. A fourth antenna unit **140** may be disposed adjacent to a fifth side surface **S5** being connected to the second side surface **S2** and the third side surface **S3** being connected to the fifth side surface **S5**. The second side surface **S2** and the fifth side surface **S5** of the substrate **1000** may form an obtuse angle, and the fifth side surface **S5** and the third side surface **S3** may form an obtuse angle. A third shielding part **403** may be disposed to face the second antenna unit **120**. A fourth shielding part **404** may be disposed to face the fourth antenna unit **140**. The third shielding part **403** and the fourth shielding part **404** may form an obtuse angle with each other.

The shielding parts **401**, **402**, **403**, and **404** may be electrically connected to a ground part of a first substrate **1000**. The shielding parts **401**, **402**, **403**, and **404** may be electrically connected to a ground part within a wireless communication module **10**. The shielding parts **401**, **402**, **403**, and **404** may be electrically connected to a ground part in a vehicle where the wireless communication module **10** is disposed. The shielding parts **401**, **402**, **403**, and **404** may induce signal noise generated in the wireless communication module **10** to the ground part. Through this, signal interference between an EVCC circuit and an antenna unit in the wireless communication module **10** can be minimized, and mutual electromagnetic influence can be minimized.

The shielding parts **401**, **402**, **403**, and **404** may absorb electromagnetic field signals generated inside or outside the wireless communication module **10** and remove them by inducing them to the surface. In addition, it is possible to minimize electromagnetic field influence according to electric field formation of an antenna in an EVCC circuit within the wireless communication module **10**. Accordingly, directivity of a signal radiated from the antenna can be enhanced, and coverage of the antenna can be increased.

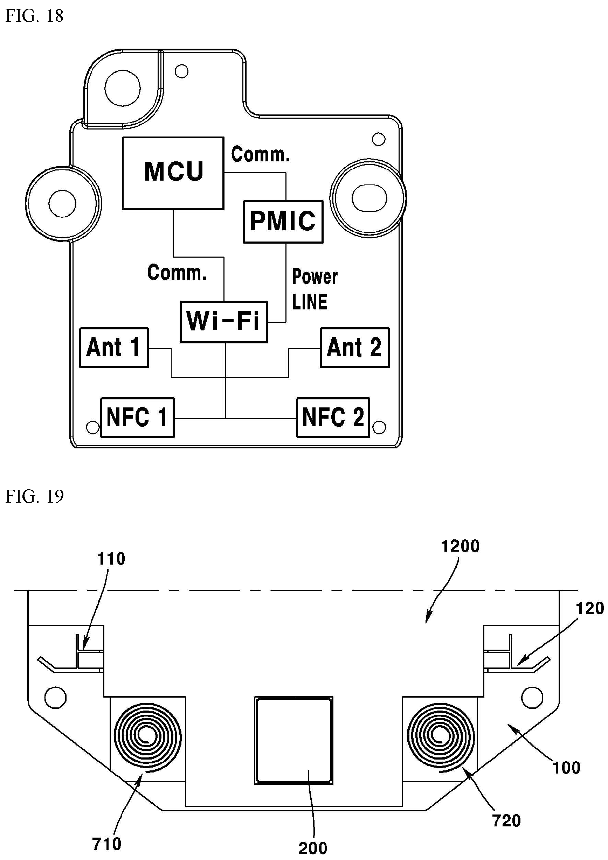

FIG. **18** is a block diagram of a wireless communication module according to another embodiment of the present invention; and FIG. **19** illustrates a wireless communication module according to another embodiment of the present invention.

Referring to FIG. 18, a wireless communication module **10** according to another embodiment of the present invention may further include a near field communication (NFC) antenna. NFC is a technology that enables communication between wireless devices at a short range and is a type of non-contact short-range wireless communication using a 13.56 MHz radio frequency (RF) band.

The wireless communication module **10** may include a first NFC antenna unit **710** and a second NFC antenna unit **720** being disposed in a first area **1100** of a substrate **1000**. The first NFC antenna unit **710** and the second NFC antenna unit **720** may include a magnetic sheet being disposed in the first area **1100** of the substrate **1000** and a magnetic induction coil being disposed on the magnetic sheet. The first NFC antenna unit **710** and the second NFC antenna unit **720** may be embedded NFC antennas. When the first NFC antenna unit **710** and the second NFC antenna unit **720** are embedded NFC antennas, they may be connected to a Wi-Fi module **200** or an EVCC configuration being disposed in a second area **1200** of the substrate **1000**.

A first NFC antenna unit **710** may be disposed to face one side of a Wi-Fi module **200**, and a second NFC antenna unit **720** may be disposed to face the other side of the Wi-Fi module **200**. The first NFC antenna unit **710** and the second NFC antenna unit **720** may be disposed at symmetrical positions with respect to the Wi-Fi module **200**. The first NFC antenna unit **710** and the second NFC antenna unit **720** may be disposed to be overlapped with each other in a first axis direction. The first NFC antenna unit **710** may be disposed so as not to be overlapped with a first antenna unit **110** in the first axis direction and a second axis direction perpendicular to the first axis direction. The second NFC antenna unit **720** may be disposed so as not to be overlapped with a second antenna unit **120** in the first axis direction and the second axis direction.

When the wireless communication module **10** includes NFC antenna units **710** and **720**, the EVSE **30** may include an NFC reader to communicate with the NFC antenna units **710** and **720**. When the vehicle **1** enters the area of the EVSE **30** and the NFC reader embedded in the EVSE **30** and the NFC antenna units **710** and **720** are in a short-range state where they can communicate with each other, communication regarding the switching to a ready mode of the vehicle **1**, information on a charging state of the vehicle, and the like is possible.

As described above, by including the NFC antenna units **710** and **720** in the wireless communication module **10**, it is possible to provide a security authentication function, charging fee billing, and vehicle information in conjunction with a mobile terminal. Unlike the antenna units that communicate using 2.4 GHz and 5 GHz in an electric field, the NFC antenna units **710** and **720** use 13.56 MHz in a magnetic field, thereby minimizing interference between frequencies and fields.

Those of ordinary skill in the art to which the present embodiment pertains will understand that the embodiment may be implemented in modified forms without departing from the essential characteristics of the above description. Therefore, the disclosed methods should be considered from an explanatory perspective rather than a restrictive one. The scope of the present invention is defined by the claims rather than the foregoing description, and all differences within the equivalent scope should be interpreted as being included in the present invention.

## Claims

1. A wireless communication module comprising:
an antenna unit disposed in a first area of a substrate; and
a Wi-Fi module disposed in a second area of the substrate,
wherein the antenna unit includes a first antenna unit and a third antenna unit being disposed at one side of the Wi-Fi module and connected to each other, and
wherein the first antenna unit and the third antenna unit radiate signals having a phase difference.

2. The wireless communication module according to claim 1,
wherein the antenna unit includes a second antenna unit and a fourth antenna unit being disposed at the other side of the Wi-Fi module and connected to each other; and
wherein the second antenna unit and the fourth antenna unit radiate signals having a phase difference.

3. The wireless communication module according to claim 2,
wherein the phase difference between the first antenna unit and the third antenna unit and the phase difference between the second antenna unit and the fourth antenna unit are different from each other.

4. The wireless communication module according to claim 1,
wherein the Wi-Fi module is connected to the first antenna unit through a second signal line being branched from a first signal line, and
wherein the Wi-Fi module is connected to the third antenna unit through a third signal line being branched from the first signal line.

5. The wireless communication module according to claim 4,
wherein the lengths of the second signal line and the third signal line are different from each other with respect to the first signal line.

6. A wireless communication module comprising:
a first case;
a second case coupling to the first case;
a substrate being disposed within the second case;
an antenna unit being disposed in a first area of the substrate; and
a Wi-Fi module being disposed in a second area of the substrate,
wherein the antenna unit includes a first antenna unit and a third antenna unit being disposed at one side of the Wi-Fi module and connected to each other, and
wherein the antenna unit includes a second antenna unit and a fourth antenna unit being disposed at the other side of the Wi-Fi module and connected to each other.

7. The wireless communication module according to claim 6,
wherein the first antenna unit and the third antenna unit radiate signals having a first phase difference,
wherein the second antenna unit and the fourth antenna unit radiate signals having a second phase difference, and
wherein the first phase difference and the second phase difference are different from each other.

8. The wireless communication module according to claim 6,
wherein the Wi-Fi module is connected to the first antenna unit through a second signal line being branched from a first signal line,
wherein the Wi-Fi module is connected to the second antenna unit through a third signal line being branched from the first signal line, and
wherein the lengths of the second signal line and the third signal line are different from each other with respect to the first signal line.

9. A wireless communication module comprising:
an antenna unit being disposed in a first area of a substrate; and
a Wi-Fi module being disposed in a second area of the substrate,
wherein the antenna unit includes a first antenna unit and a third antenna unit being disposed at one side of the Wi-Fi module and connected to each other; and
wherein the wireless communication module includes a shielding part between the first area and the second area of the substrate.

10. The wireless communication module according to claim 9,
wherein the first antenna unit and the third antenna unit are not overlapped in a first axis direction and a second axis direction perpendicular to the first axis direction, and
wherein the shielding part includes a first shielding part facing the first antenna unit and a second shielding part facing the third antenna unit.
